# FASCICULE DE BREVET EUROPEEN

(11) **EP 0 884 770 B1**
(45) Date de publication et mention de la délivrance du brevet: **13.01.2010**
(21) Numéro de dépôt: 98401383.9
(22) Date de dépôt: 09.06.1998
(51) Int. Cl.: H01L 21/285, H01L 21/3205

(54) **Procédé de dépôt d'une couche d'un matériau polycristallin sur un substrat contenant du silicium.**
Verfahren zur Abscheidung einer Schicht aus polykristallinem Material über einem Silizium enthaltenden Substrat
Method of depositing a polycristalline material layer on a silicon containing substrate

(30) Priorité: 13.06.1997 FR 9707348
(43) Date de publication de la demande: 16.12.1998
(73) Titulaire: Chartoleaux KG Limited Liability Company, Wilmington, DE 19808 (US)
(72) Inventeur: Regolini, Jorge Luis, 38190 Bernin (FR)
(74) Mandataire: Loisel, Bertrand

(56) Documents cités:
- EP-A- 0 325 328
- US-A- 4 540 607
- YOUNG-BAE PARK ET AL: "EFFECT OF HYDROGEN PLASMA PRECLEANING ON THE REMOVAL OF INTERFACIAL AMORPHOUS LAYER IN THE CHEMICAL VAPOR DEPOSITION OF MICROCRYSTALLINE SILICON FILMS ON SILICON OXIDE SURFACE" APPLIED PHYSICS LETTERS, vol. 68, no. 16, 15 avril 1996, pages 2219-2221, XP000585161

## Description

La présente invention concerne d'une manière générale un procédé de dépôt chimique en phase aqueuse (CVD) d'un matériau polycristallin tel que du silicium, un siliciure métallique, par exemple TiSi₂, du germanium ou encore un mélange germanium/silicium polycristallin sur la surface d'un substrat à base de silicium, par exemple un substrat en silicium monocristallin (Si mono), oxyde de silicium (SiO₂) ou en nitrure de silicium (Si₃N₄).

La granulométrie des dépôts de matériaux polycristallins par CVD tels que TiSi₂ sur Si mono, Si polycristallin sur SiO₂, Ge polycristallin sur SiO₂, est fonction de la température de dépôt, de la pression de travail et de l'état de surface du substrat.

Ces dépôts de matériaux polycristallins par CVD sont maintenant couramment utilisés pour la fabrication de dispositifs semiconducteurs, en particulier pour la métallisation drain/source et la réalisation d'interconnexions. Ainsi, le document FR-A-95 15327 décrit un procédé de dépôt par CVD de TiSi₂ pour la siliciuration des régions drain/source et des interconnexions de dispositifs semiconducteurs.

Que l'étape de dépôt sur le substrat soit une étape de dépôt par épitaxie ou de dépôt CVD, il est usuel de soumettre la surface de dépôt du substrat à une ou plusieurs étapes préalables de préparation, généralement une ou plusieurs étapes de nettoyage. Ainsi, dans le cas d'un substrat de silicium, il est nécessaire de retirer l'oxyde natif, le carbone et toute autre impureté présente avant de procéder à un dépôt épitaxial ou par CVD. Ces étapes de nettoyage laissent la surface du substrat propre et lisse, de sorte que la nucléation du dépôt ultérieur est principalement induite par la température et la pression de dépôt.

On a déjà proposé d'utiliser des méthodes de nettoyage assistées par plasma pour la préparation des surfaces de substrats de silicium en vue d'un dépôt épitaxial ultérieur.

Le document EP-91 420 461.5 décrit une méthode de nettoyage assistée par plasma de la surface d'un substrat de silicium comprenant une première phase de nettoyage au moyen d'un plasma d'argon et une seconde phase de nettoyage au moyen d'un plasma d'hydrogène en vue d'un dépôt épitaxial ultérieur. Une caractéristique importante de ce procédé est d'obtenir une surface propre aussi lisse que possible, c'est-à-dire ayant une rugosité aussi faible que possible.

Un des problèmes du dépôt d'un matériau polycristallin par CVD sur une surface propre et lisse d'un substrat à base de silicium est la taille des grains, trop importante pour la réalisation de lignes de faibles dimensions.

La demanderesse a maintenant découvert, qu'en soumettant la surface d'un substrat à base de silicium avant dépôt par CVD sur cette surface d'un matériau polycristallin à une irradiation par un plasma de gaz choisi, dans des conditions prédéterminées, il était possible d'obtenir une surface propre ayant une rugosité réglée de telle sorte que la surface traitée sert de couche de nucléation pour un dépôt par CVD de matériau polycristallin. On obtient ainsi une couche de matériau polycristallin ayant une densité de nucléation importante et donc une granulométrie plus fine, réglée.

La présente invention fournit donc un procédé de dépôt d'un matériau polycristallin sur une surface d'un substrat contenant du silicium, caractérisé en ce qu'il comprend :
a) le traitement de la surface du substrat au moyen d'un plasma gazeux d'hydrogène, argon, azote, ammoniac ou d'un mélange de ceux-ci, les ions du plasma ayant une énergie comprise entre 2 et 100 eV et la température du substrat étant comprise entre la température ambiante et 400°C pour induire à la surface une rugosité réglée ayant une valeur pic-vallée de 0,5 à 25 nm la durée du traitement par plasma étant de l'ordre de une minute; et
b) le dépôt chimique en phase vapeur (CVD) sur la surface traitée du substrat d'une couche d'un matériau polycristallin ayant une granulométrie prédéterminée inférieure à 20 nm.

Les substrats à base de silicium utiles dans le procédé de dépôt selon l'invention comprennent les substrats en silicium, amorphes ou cristallins, en oxyde de silicium (SiO₂), en nitrure de silicium (Si₃N₄) et en oxynitrure de silicium (SiOₓN_{y} où x ≤ 3 et y ≤ 4). Les substrats préférés sont le silicium, SiO₂ et Si₃N₄.

Parmi les matériaux polycristallins utiles pour le dépôt CVD selon l'invention, on peut citer les siliciures métalliques tels que les siliciures de métaux réfractaires, par exemple TiSi₂, le silicium polycristallin, le germanium polycristallin et les mélanges Si/Ge polycristallins (SiₓGe₁₋ₓ, où x < 1). Les matériaux polycristallins préférés sont le siliciure de titane (TiSi₂), le silicium polycristallin et le germanium polycristallin.

Une caractéristique essentielle du procédé de l'invention est le traitement d'une surface du substrat au moyen d'un plasma gazeux doux pour induire sur cette surface une rugosité réglée ayant une valeur pic-vallée comprise entre 0,5 et 25 nm. L'importance de la rugosité (valeur pic-vallée) dépend des conditions du plasma, nature du ou des gaz, énergie des ions, de la température et de la nature du substrat, ainsi que de la durée du traitement.

Ainsi, lorsque le substrat est du silicium, la valeur pic-vallée des rugosités induites sera généralement de l'ordre de 5 à 20 nm, de préférence 10 à 15 nm. Lorsque le substrat est une couche mince de SiO₂ d'épaisseur généralement comprise entre 5 et 10 nm, la valeur pic-vallée des rugosités induites sera de l'ordre de 10% environ de l'épaisseur de cette couche, c'est-à-dire de 0,5 à 1 nm.

Les plasmas gazeux doux utilisables dans la présente invention sont classiques et connus. Les gaz utiles pour la réalisation de ces plasmas sont l'hydrogène, l'argon, l'azote, l'ammoniac et leurs mélanges. Les gaz préférés pour le plasma sont l'hydrogène, l'argon et les mélanges hydrogène/argon.

L'utilisation d'un plasma d'hydrogène dans cette étape de traitement a également pour effet de passiver la surface du substrat à base de silicium, en particulier d'un substrat de silicium. Une telle passivation est particulièrement avantageuse lorsque le traitement par plasma n'est pas fait in situ, par exemple dans un système de réacteurs en "grappe" (Cluster).

L'énergie des ions du plasma utile dans la présente invention est comprise entre 2 et 100 eV, de préférence, d'environ 50 eV.

La température du substrat lors de cette étape de traitement par plasma est comprise entre la température ambiante et 400°C, de préférence entre 100 et 350°C.

La durée du traitement par plasma est de l'ordre de la minute.

Cette étape de traitement par plasma peut être mise en oeuvre avec ou sans polarisation du substrat.

Cette étape de traitement par plasma peut être mise en oeuvre dans un réacteur séparé ou dans un système du type "grappe" (Cluster) monoplaque.

Le dépôt chimique en phase vapeur d'un matériau polycristallin est classique et bien connu dans la technique. Par exemple, le dépôt CVD de siliciures métalliques est décrit entre autres dans le document FR-A-95 15 327 et on pourra se reporter à ce document pour de plus amples informations quant aux conditions d'un tel dépôt.

Les dépôts CVD de silicium et de germanium polycristallins sont également bien connus.

### Exemple: Dépôt d'une couche de TiSi₂ sur un substrat de silicium.

On nettoie une plaquette de silicium (enlèvement de l'oxyde natif) avec de l'acide fluorhydrique. La plaquette nettoyée est placée dans une chambre d'un réacteur multichambres ("Cluster tool") et on soumet une surface de la plaquette à un plasma d'hydrogène ayant une énergie de 50 eV pendant une minute et à la température ambiante.

La plaquette de silicium ainsi traitée est soumise à un dépôt chimique en phase vapeur de TiSi₂ dans une chambre de dépôt du réacteur multichambres. L'atmosphère utilisée était une atmosphère H₂/TiCl₄/SiH₄/SiH₂Cl₂ et la température de dépôt était de 750°C.

L'observation du dépôt obtenu au microscope électronique à balayage montre que l'on a obtenu une couche de TiSi₂ ayant une granulométrie fine et régulière.

## Revendications

1. Procédé de dépôt d'un matériau polycristallin sur une surface d'un substrat contenant du silicium, **caractérisé en ce qu'**il comprend :
a) le traitement de la surface du substrat au moyen d'un plasma gazeux d'hydrogène, argon, azote, ammoniac ou d'un mélange de ces gaz, les ions du plasma gazeux ayant une énergie comprise entre 2 et 100 eV et la température du substrat étant comprise entre la température ambiante et 400°C, pour induire dans la surface traitée une rugosité réglée ayant une valeur pic-vallée de 0,5 à 25 nm, la durée du traitement par plasma étant de l'ordre de une minute : et
b) le dépôt chimique en phase vapeur sur la surface ainsi traitée du substrat pour obtenir une couche d'un matériau polycristallin ayant une granulométrie prédéterminée inférieure à 20 nm.

2. Procédé selon la revendication 1, **caractérisé en ce que** le plasma est un plasma d'hydrogène, un plasma d'argon ou un plasma H₂/Ar.

3. Procédé selon la revendication 1 ou 2, **caractérisé en ce que** le substrat contenant du silicium est choisi parmi les substrats de silicium, d'oxyde de silicium, de nitrure de silicium et d'oxynitrure de silicium.

4. Procédé selon l'une quelconque des revendications 1 à 3, **caractérisé en ce que** le matériau polycristallin est choisi parmi les siliciures métalliques, le silicium, le germanium et les mélanges Si/Ge.

5. Procédé selon la revendication 1 ou 2, **caractérisé en ce que** le substrat est du silicium, le matériau polycristallin est du siliciure de titane et la rugosité induite a une valeur pic-vallée de 5 à 20 nm.

6. Procédé selon la revendication 1 ou 2, **caractérisé en ce que** le substrat est de l'oxyde de silicium (SiO₂), le matériau polycristallin est du silicium, du germanium ou un mélange Si/Ge et la rugosité induite a une valeur pic-vallée de 0,5 à 1 nm.

7. Procédé selon l'une quelconque des revendications précédentes, **caractérisé en ce que** les ions du plasma ont une énergie de 50 eV, environ.

8. Procédé selon l'une quelconque des revendications précédentes, **caractérisé en ce que** la température du substrat lors du traitement par plasma est comprise entre 100 et 350°C.

## Claims

1. Process for depositing a polycrystalline material on a surface of a substrate containing silicon, **characterized in that** it comprises:
a) treating of the surface of the substrate by means of a hydrogen, argon, nitrogen or ammonia gas plasma or a plasma of a mixture of these gases, the ions in the gas plasma having an energy of between 2 and 100 eV and the temperature of the substrate being between ambient temperature and 400 °C in order to induce in the treated surface a controlled roughness having a peak-to-valley value of 0.5 to 25 nm, the duration of the plasma treatment being of the order of one minute; and
b) performing chemical vapor deposition on the surface of the substrate thus treated to obtain a layer of a polycrystalline material having a predetermined grain size of less than 20 nm.

2. Process according to claim 1, **characterized in that** the plasma is a hydrogen plasma, an argon plasma or an H₂/Ar plasma.

3. Process according to claim 1 or 2, **characterized in that** the substrate containing silicon is chosen from silicon, silicon oxide, silicon nitride and silicon oxynitride substrates.

4. Process according to any one of claims 1 to 3, **characterized in that** the polycrystalline material is chosen from metal silicides, silicon, germanium and Si/Ge mixtures.

5. Process according to claim 1 or 2, **characterized in that** the substrate is silicon, the polycrystalline material is titanium silicide and the induced roughness has a peak-to-valley value of 5 to 20 nm.

6. Process according to Claim 1 or 2, **characterized in that** the substrate is silicon oxide (SiO₂), the polycrystalline material is silicon, germanium or a Si/Ge mixture and the induced roughness has a peak-to-valley value of 0.5 to 1 nm.

7. Process according to any one of the preceding claims, **characterized in that** the ions in the plasma have an energy of approximately 50 eV.

8. Process according to any one of the preceding claims, **characterized in that** the temperature of the substrate during the plasma treatment is between 100 and 350 °C.

## Patentansprüche

1. Verfahren zur Abscheidung eines polykristallinen Materials auf einer Oberfläche eines Silizium enthaltenden Substrats, **dadurch gekennzeichnet, dass** es umfasst:
a) die Behandlung der Oberfläche des Substrats mittels eines gasförmigen Plasmas aus Wasserstoff, Argon, Stickstoff, Ammoniak oder aus einer Mischung dieser Gase, wobei die Ionen des gasförmigen Plasmas eine Energie zwischen 2 und 100 eV aufweisen und die Temperatur des Substrats zwischen Umgebungstemperatur und 400 °C beträgt, um in der behandelten Oberfläche eine geregelte Rauigkeit zu induzieren, die einen Berg-Tal-Abstand von 0,5 bis 25 aufweist, wobei die Dauer der Behandlung mittels des Plasmas in der Größenordung einer Minute liegt; und
b) die chemische Dampfabscheidung auf der auf diese Weise behandelten Oberfläche des Substrats, um eine Schicht eines polykristallinen Materials zu erhalten, das eine vorbestimmte Korngröße von kleiner als 20 nm aufweist.

2. Verfahren nach Anspruch 1, **dadurch gekennzeichnet, dass** das Plasma ein Wasserstoffplasma, ein Argonplasma oder ein H₂/Ar-Plasma ist.

3. Verfahren nach Anspruch 1 oder 2, **dadurch gekennzeichnet, dass** das Silizium enthaltenden Substrat ausgewählt ist aus Siliziumsubstraten, Siliziumoxidsubstraten, Siliziumnitridsubstraten und Siliziumoxynitridsubstraten.

4. Verfahren nach einem der Ansprüche 1 bis 3, **dadurch gekennzeichnet, dass** das polykristalline Material ausgewählt ist aus Metallsiliciden, Silizium, Germanium und Si/Ge-Mischungen.

5. Verfahren nach Anspruch 1 oder 2, **dadurch gekennzeichnet, dass** das Substrat Silizium ist, das polykristalline Material Titansilicid ist und die induzierte Rauigkeit einen Berg-Tal-Abstand von 5 bis 20 nm aufweist.

6. Verfahren nach Anspruch 1 oder 2, **dadurch gekennzeichnet, dass** das Substrat Siliziumdioxid (SiO₂) ist, das polykristalline Material Silizium, Germanium oder eine Si/Ge-Mischung ist und die induzierte Rauigkeit einen Berg-Tal-Abstand von 0,5 bis 1 nm aufweist.

7. Verfahren nach einem der vorhergehenden Ansprüche, **dadurch gekennzeichnet, dass** die Plasmaionen eine Energie von ungefähr 50 eV aufweisen.

8. Verfahren nach einem der vorhergehenden Ansprüche, **dadurch gekennzeichnet, dass** die Temperatur des Substrats während der Behandlung mittels des Plasmas zwischen 100 und 350 °C beträgt.
